# EUROPEAN PATENT APPLICATION

(11) **EP 1 536 492 A2**
(43) Date of publication of application: **01.06.2005**
(21) Application number: 04027858.2
(22) Date of filing: 24.11.2004
(51) Int. Cl.: H01L 51/20

(54) **Electroluminescent element and lighting unit**

(30) Priority: 25.11.2003 JP 2003393200
(71) Applicant: Kabushiki Kaisha Toyota Jidoshokki, Kariya-shi, Aichi-ken (JP)
(72) Inventor: Utsumi, Tetsuya, K.K. Toyota Jidoshokki, Kariya-shi Aichi-ken (JP); Tsuzuki, Toshihiko, K.K. Toyota Jidoshokki, Kariya-shi Aichi-ken (JP); Ishikawa, Haruyuki, K.K. Toyota Jidoshokki, Kariya-shi Aichi-ken (JP); Takeuchi, Norihito, K.K. Toyota Jidoshokki, Kariya-shi Aichi-ken (JP)
(74) Representative: Leson, Thomas Johannes Alois, Dipl.-Ing.

(57) **Abstract**

In an electroluminescent element, a first electrode having first and second opposite surfaces is layered on a substrate so as to contact the substrate on its first surface. A luminescent layer containing a light-emitting layer is layered on the first electrode so as to contact the second surface of the first electrode. A second electrode having first and second opposite surfaces is layered on the luminescent layer so as to contact the luminescent layer on its first surface. The second surface of the second electrode is at least partially exposed. A first terminal is provided on the second surface of the first electrode at a portion that does not contact the luminescent layer. A second terminal is partially formed in the exposed portion. At least one of the first and second electrodes is transparent. The first and second terminals are connected to a power source.

## Description

### BACKGROUND OF THE INVENTION

The present invention relates to an electroluminescent element and a lighting unit including the electroluminescent element.

An electroluminescent element or an EL element is formed by layering an electroluminescent material and the like on its substrate. The EL element, which emits light from the side of a glass substrate, generally has a transparent electrode on the side of the substrate relative to its luminescent layer (EL layer) containing an electroluminescent material and also has a metallic electrode on the opposite side to the substrate. In order to prevent the EL layer from degrading due to moisture or oxygen, the transparent electrode, the organic layer and the metallic electrode are sealed by a sealing member.

On the other hand, there is an invention which does not provide a sealing member on a metallic electrode for enhancing heat radiation performance, as disclosed in Examined Japanese Patent Publication No. 6-32297. There is another invention that utilizes a thickened metallic electrode as a sealing member, as disclosed in Unexamined Japanese Patent Publication No. 2003-217854.

A portion of an electrode which is not sealed by the sealing member may be used for a terminal which is electrically connected to a power source. Also, a plurality of EL elements may be arranged to form a lighting unit.

### SUMMARY OF THE INVENTION

In accordance with the present invention, an electroluminescent element has a substrate, a first electrode, a luminescent layer, a second electrode, a first terminal and a second terminal. The first electrode has a first surface and a second surface that is opposite to the first surface. The first electrode is layered on the substrate so as to contact the substrate on its first surface. The luminescent layer, which contains a light-emitting layer, is layered on the first electrode so as to contact the second surface of the first electrode. The second electrode has a first surface and a second surface that is opposite to the first surface. The second electrode is layered on the luminescent layer so as to contact the luminescent layer on its first surface. The second surface of the second electrode is at least partially exposed. The first terminal is provided on the second surface of the first electrode at a portion that does not contact the luminescent layer. The second terminal is partially formed in the exposed portion of the second surface of the second electrode. At least one of the first electrode and the second electrode is transparent. The first terminal and the second terminal are connected to a power source.

Other aspects and advantages of the invention will become apparent from the following description, taken in conjunction with the accompanying drawings, illustrating by way of example the principles of the invention.

### BRIEF DESCRIPTION OF THE DRAWINGS

The features of the present invention that are believed to be novel are set forth with particularity in the appended claims. The invention together with objects and advantages thereof, may best be understood by reference to the following description of the presently preferred embodiments together with the accompanying drawings in which:
FIG. 1A is a schematic cross-sectional view of an organic electroluminescent element according to a first preferred embodiment of the present invention;
FIG. 1B is a schematic front end view of the organic electroluminescent element according to the first preferred embodiment of the present invention;
FIG. 2A is a schematic view showing one aspect of a manufacturing process of the organic electroluminescent element according to the first preferred embodiment of the present invention;
FIG. 2B is a schematic view showing another aspect of the manufacturing process of the organic electroluminescent element according to the first preferred embodiment of the present invention;
FIG. 2C is a schematic view showing yet another aspect of the manufacturing process of the organic electroluminescent element according to the first preferred embodiment of the present invention;
FIG. 3A is a schematic cross-sectional view of an organic electroluminescent element according to a second preferred embodiment of the present invention;
FIG. 3B is a schematic front end view of the organic electroluminescent element according to the second preferred embodiment of the present invention;
FIG. 4A is a schematic back side view of a lighting unit according to a third preferred embodiment of the present invention; and
FIG. 4B is a schematic cross-sectional view of the lighting unit according to the third preferred embodiment of the present invention.

### DETAILED DESCRIPTION OF THE PREFERRED EMBODIMENTS

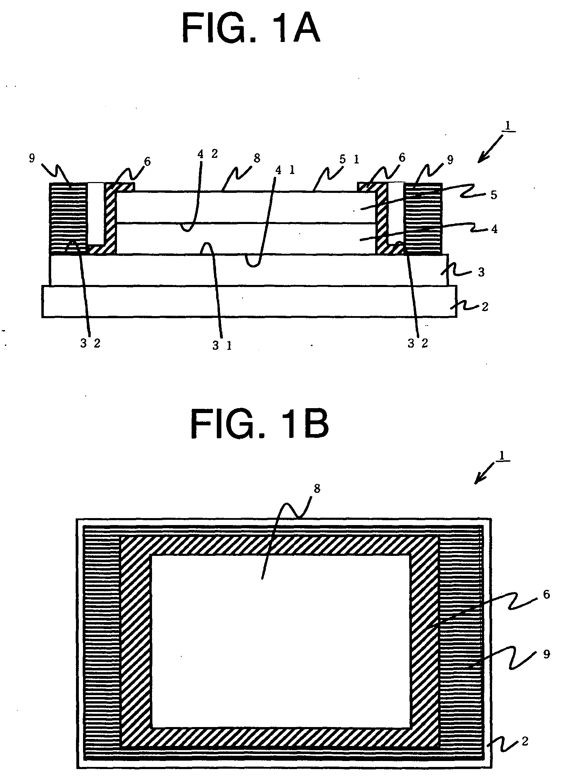

A first preferred embodiment of an electroluminescent element, which is applied to an organic electroluminescent element or an organic EL element 1 employing an organic compound in its electroluminescent layer (EL layer) according to the present invention, will now be described with reference to FIGS. 1A through 2C. It is noted that a slanted line for indicating cross-section is partially omitted, and the same components are indicated with the same slanted lines for easier recognition irrespective of the cross-sectional view and the front end view in FIGS. 1A through 2C.

As shown in FIG. 1A, the organic EL element 1 has an anode or a first electrode 3, an organic layer 4 containing a light-emitting layer, and a cathode or a second electrode 5 on its substrate 2 in this order. In other words, the anode 3 has a first surface and a second surface that is opposite to the first surface, and is layered on the substrate 2 so as to contact the substrate 2 on its first surface. The organic layer 4 is layered on the anode 3 so as to contact the second surface of the anode 3. The cathode 5 has a first surface and a second surface that is opposite to the first surface. The cathode 5 is layered on the organic layer 4 so as to contact the organic layer 4 on its first surface. The anode 3 includes a contact portion 31 that contacts the organic layer 4 and a non-contact portion 32 that does not contact the organic layer 4. In the first preferred embodiment, the non-contact portion 32 is provided at a periphery of the anode 3. The organic layer 4 contacts the anode 3 by the entire surface of one side 41 and contacts the cathode 5 by the entire surface of the other side 42.

A sealing layer or a sealing member 6 is deposited to cover the end surface of the organic layer 4, the end surface of the cathode 5, and the periphery of an opposite surface 51 to a surface that contacts the organic layer 4 of the cathode 5. A portion, which is not covered with the sealing layer 6 in the opposite surface 51 to the surface that contacts the organic layer 4 of the cathode 5, is exposed thus forming a cathode terminal or a second terminal 8. Also, an anode terminal or a first terminal 9 is provided at the non-contact portion 32, which does not contact the organic layer 4 of the anode 3. Accordingly, in the organic EL element 1 according to the first preferred embodiment, as seen from the side of the cathode 5, the cathode terminal 8 is positioned at the center, and the anode terminal 9 is arranged around the cathode terminal 8 via the sealing layer 6, as shown in FIG. 1B.

Each component of the organic EL element 1 will now be described.

The substrate 2 is made of glass in the first preferred embodiment but may be made of any transparent materials having a sufficient strength when the anode 3 and the organic layer 4 are deposited thereon. Other than glass, such a material may include a transparent resin.

The anode 3 supplies positive holes to the organic layer 4, and light emitted from the organic layer 4 is emitted outside through the anode 3 and the substrate 2 in the first preferred embodiment, so that the anode 3 needs to be transparent. In the first preferred embodiment, a material for the anode 3 is ITO (indium tin oxide), but the material may be IZO (indium zinc oxide) and the like.

The organic layer 4 needs to have at least a light-emitting layer. The light-emitting layer emits light by recombination of positive holes supplied from the anode 3 and electrons supplied from the cathode 5. The light-emitting layer may be made of a single organic compound or may be made of plural organic compounds.

When the light-emitting layer is made of plural organic compounds, each layer made of an organic compound may be plurally layered, or may be made of a layer which mixes plural organic compounds.

The organic layer 4 may partially or wholly include a positive hole injection layer or a positive hole transport layer for efficiently transporting positive holes supplied from the anode 3 to the light-emitting layer, and an electron injection layer or an electron transport layer for efficiently transporting electrons supplied from the cathode 5 to the light-emitting layer, in addition to the light-emitting layer. Also, a single layer may have plural functions.

Specifically, the organic layer 4 may be constituted of the following layer structures.
- (Anode) / Positive Hole Injection Layer / Positive Hole Transport Layer / Light-emitting Layer / Electron Transport Layer / Electron Injection Layer / (Cathode)
- (Anode) / Positive Hole Injection Layer / Positive Hole Transport Layer / Light-emitting Layer / Electron Injection Transport Layer / (Cathode)
- (Anode) / Positive Hole Injection Transport Layer / Light-emitting Layer / Electron Transport Layer / Electron Injection Layer / (Cathode)
- (Anode) / Positive Hole Injection Transport Layer / Light-emitting Layer / Electron Injection Transport Layer / (Cathode)
- (Anode) / Positive Hole Transport Layer / Light-emitting Layer / Electron Transport Layer / Electron Injection Layer / (Cathode)
- (Anode) / Positive Hole Transport Layer / Light-emitting Layer / Electron Transport Layer / (Cathode)
- (Anode) / Positive Hole Transport Layer / Electron Transport Light-emitting Layer / (Cathode)
- (Anode) / Light-emitting Layer / (Cathode)

The organic layer 4 according to the first preferred embodiment is constituted of a positive hole transport layer, a light-emitting layer, an electron transport layer and an electron injection layer, and has a three-layer structure in which a green light-emitting layer, a blue light-emitting and a red light-emitting layer are layered from the contact portion 31 of the anode 3.

The cathode 5 supplies electrons to the organic layer 4, and is made of a material having an electrical conductivity and preferably made of a material having a low resistivity. Such a material includes a metal, an alloy and a metallic mixture. In the first preferred embodiment, the cathode 5 is made of aluminum.

Since a non-covered portion of the cathode 5 that is not covered with the sealing layer 6 is exposed, to prevent a substance such as moisture and oxygen from degrading the organic layer 4 by entering into the organic EL element 1 through the portion 51, the thickness of the cathode 5 is preferably 0.5 µm or above, and more preferably 1.5 µm or above. Also, when the cathode 5 is formed by vapor deposition, the thickness of the cathode 5 is preferably 5 µm or below, and more preferably 3 µm or below. When the cathode terminal 8 is provided on the portion 51 that is not covered with the sealing layer 6 by vapor deposition, bonding, and the like after forming the cathode 5, the thickness of the cathode terminal 8 is preferably 1 mm or below, and more preferably 300 µm or below.

The sealing layer 6 serves to prevent the organic layer 4 from being degraded due to moisture in the atmosphere or oxygen, and is made of a material having a high airtightness. Such a material includes organic polymeric materials, inorganic materials, and the like. The organic polymeric materials include epoxy resin, silicone resin, polystyrene resin and the like. The inorganic material includes glass, metal oxide, metal nitride and the like. In the first preferred embodiment, a silicon nitride layer, which is an inorganic material, is used as the sealing layer 6.

The anode terminal 7 is connected to a power source (not shown) and serves to supply positive holes to the anode 3. The anode terminal 7 may be made of the same material as the cathode 5. In the first preferred embodiment, aluminum is employed for the anode terminal 7 as well as the cathode 5.

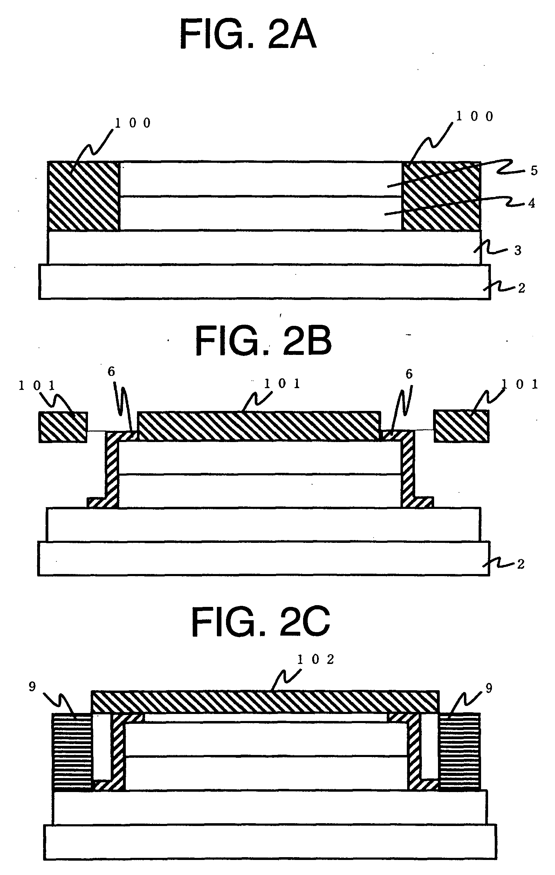

A method of manufacturing the organic EL element 1 will now be described with reference to FIGS. 2A through 2C.

The substrate 2, which is provided with the anode 3 of a desired shape on its surface, is washed and after that is placed in a vacuum evaporator (not shown). In the vacuum evaporator, as shown in FIG. 2A, a positive hole transport layer is vapor-deposited after a mask 100 is placed on the periphery of the anode 3. Then, the light-emitting layer is vapor-deposited on the positive hole transport layer, in the order of a green light-emitting, a blue light-emitting and a red light-emitting. Subsequently, an electron transport layer and an electron injection layer are vapor-deposited on the light-emitting layer, in this order, thus forming the organic layer 4. Additionally, aluminum is vapor-deposited on the organic layer 4 to form the cathode 5. After forming the cathode 5, the mask 100 is removed.

As shown in FIG. 2B, a mask 101 is placed to form the sealing layer 6. After forming the sealing layer 6, the mask 101 is removed. After that, as shown in FIG. 2C, a mask 102 is placed, and aluminum is vapor-deposited, thus forming the anode terminal 9.

The operation of the organic EL element 1 will now be described.

The positive electrode of a direct-current power source (not shown) is connected to the anode terminal 9, and the negative electrode thereof is connected to the cathode terminal 8 thereby applying a voltage so that the electric potential of the anode terminal 9 is higher than that of the cathode terminal 8. Positive holes are supplied, from the positive electrode of the direct-current power source, through the anode terminal 9 and the anode 3 to the organic layer 4. The positive holes, which have reached the anode 3, move to the light-emitting layer through the positive hole transport layer in the organic layer 4. On the other hand, electrons are supplied from the negative electrode of the direct-current power source through the cathode terminal 9 to the cathode 5. The electrons, which have reached the cathode 5, advance to the light-emitting layer through the electron injection layer and the electron transport layer in the organic layer 4.

Positive holes from the anode 3, which have reached the light-emitting layer, and electrons from the cathode 5, which have reached to the light-emitting layer, recombine to generate excitons thereby emitting light when the excitons return to a ground state. In the first preferred embodiment, the light-emitting layer is a three-layer structure, and these three layers respectively emit green light, blue light and red light. These lights are mixed together and are visible as white light.

A portion of light emitted from the light-emitting layer is directly emitted outside from the substrate 2 through the anode 3. The other light reaches the cathode 5. The cathode 5, which is made of aluminum, has a light reflectivity, so that light which has reached the cathode 5 is reflected and is emitted outside from the substrate 2 through the organic layer 4 and the anode 5.

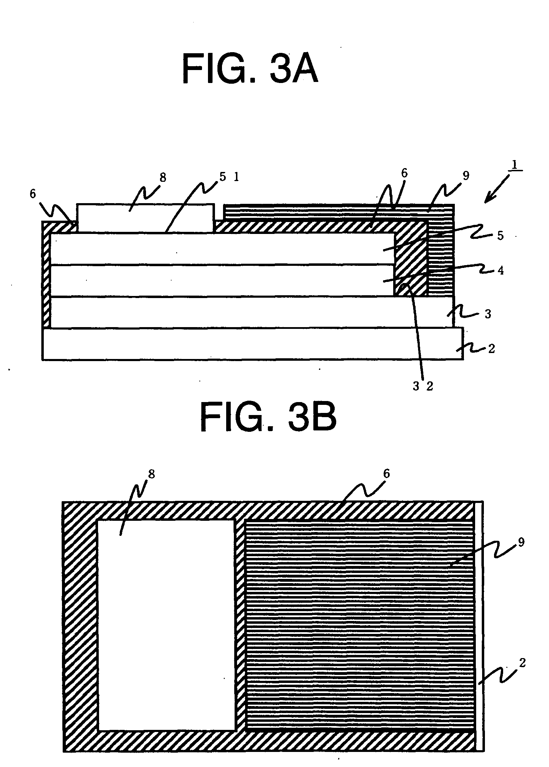

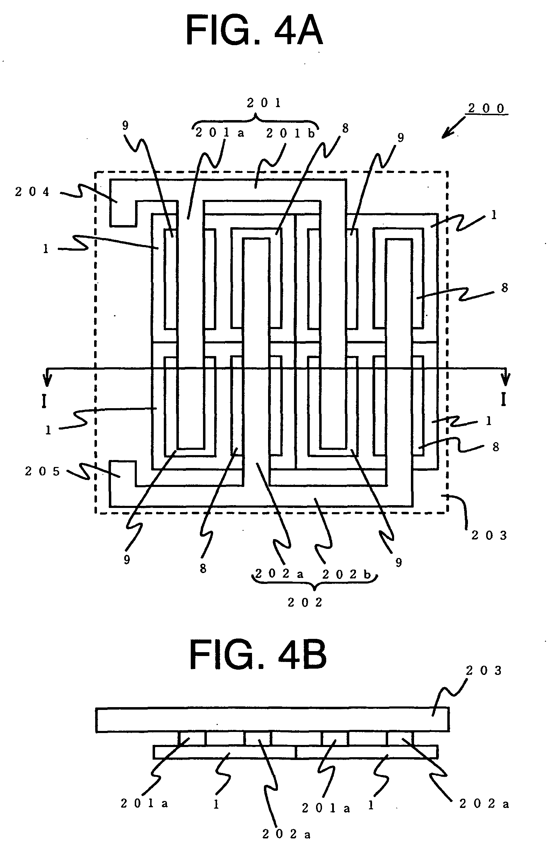

According to the first preferred embodiment, the following advantageous effects are obtained.
(1) The non-covered portion of the cathode 5 which is not covered with the sealing layer 6 forms the cathode terminal 8.
   Since the entire surface of the opposite surface 51 of the cathode 5 is not covered with the sealing layer 6, and only its periphery is covered with the sealing layer 6, the exposed portion, which is not covered with the sealing layer 6, is used as the cathode terminal 8, and is connected to an external power source. Accordingly, since the cathode terminal 8 may be provided on an opposite side of a light output side of the organic EL element 1, while the cathode terminal 8 need not be provided on a portion other than the portion of the substrate 2 where the organic layer 4 is provided, the area of the substrate 2 for the same area of the organic layer 4 may be reduced. In other words, the area contributing to light emission may be increased in the area of the substrate 2.
(2) The cathode 5 has an airtightness.
   Since the cathode 5 has a thickness of 0.5 µm or above, the cathode 5 has a sufficient airtightness. That is, the cathode 5 prevents a substance such as moisture and oxygen from degrading the organic layer 4 by entering into the organic EL element 1 through the cathode 5. Therefore, even if the entire surface of the opposite surface 51 of the cathode 5 is not covered with the sealing layer 6, and the exposed portion, which is not covered with the sealing layer 6, is used as the cathode terminal 8, the organic EL element 1 is prevented from degrading due to moisture or oxygen entering from the outside and shortening the life thereof.
(3) The organic layer 4 is not exposed.
   After the organic layer 4 is formed to contact the anode 3, the cathode 5 is formed to contact the entire surface of the opposite surface 42 of the organic layer 4. Since the sealing layer 6 is deposited on that basis, the sealing layer 6 seals the entire portion, other than the surface 41 and the surface 42. Accordingly, the organic layer 4 is covered on its outer surface with the anode 3, the cathode 5 and the sealing layer 6, so that there is no exposed portion. Therefore, degradation of the organic layer 4 due to entry of moisture or oxygen is prevented.
(4) The organic EL element 1 emits white light.
   The light-emitting layer of the organic layer 4 is constituted of a layer for emitting green light, a layer for emitting blue light and a layer for emitting red light. As voltage is applied to the organic EL element 1, these layers simultaneously emit light thereby emitting white light as a whole. Since the white light emitted from the organic EL element 1 has peaks in a red color spectral range, a blue color spectral range and a green color spectral range, clear color is generated when displaying an image through an RGB color filter.
(5) Utilization rate of light is high.
   An aluminum thin film having a light reflectivity is employed as the cathode 5. Therefore, light-traveling from the light-emitting layer to the cathode 5 is reflected toward the substrate 2 on the cathode 5, and the reflected light is partially emitted outside from the substrate 2. Accordingly, in comparison to the cathode 5 made of a material having no light reflectivity, more light that is emitted from the light-emitting layer is emitted from the substrate 2.
   A second preferred embodiment of the present invention will now be described with reference to FIGS. 3A and 3B. The second preferred embodiment is different from the first preferred embodiment in that the positions of the anode terminal 9 and the cathode terminal 8 are different. The same reference numerals denote the substantially identical components to those of the first preferred embodiment, and portions different from the first preferred embodiment will mainly be described. It is noted that a slanted line for indicating cross-section is partially omitted. For easier recognition, the same components are indicated with the same slanted lines and the like, irrespective of a cross-sectional view and a front end view in FIGS. 3A and 3B.
   In the organic EL element 1 according to the second preferred embodiment, the non-contact portion 32 with the organic layer 4 is only provided along one side of the anode 3. The sealing layer 6 is formed to cover substantially half (the right half in FIG. 3A) of the opposite surface 51 of the cathode 5. As shown in FIGS. 3A and 3B, the anode terminal 9 is formed to extend from the non-contact portion 32 of the anode 3 to the portion where the sealing layer 6 covers the opposite surface 51 of the cathode 5.
   The cathode terminal 8 is provided to contact the non-covered portion 51 of the opposite surface of the cathode 5, which is not covered with the sealing layer 6. The surface of the anode terminal 9 and the surface of the cathode terminal 8 are included in the substantially same plane.
   Such an organic EL element may be manufactured as follows. That is, in a manufacturing process of the anode terminal 9, similar to the manufacturing method described for the first preferred embodiment, aluminum is vapor-deposited on the non-covered portion 51 of the cathode 5, which is not covered with the sealing layer 6, without screening by a mask. As manufactured above, the anode terminal 9 and the cathode terminal 8 are formed at the same time.
   According to the second preferred embodiment, in addition to the advantageous effects (1) through (5) of the first preferred embodiment, the following advantageous effects are obtained.
(6) The anode terminal 9 and the cathode terminal 8 are arranged in line.
   The anode terminal 9 is provided to contact the surface of the sealing layer 6 on the side opposite to the cathode 5, to cover a portion of the cathode 5, which is covered by the sealing layer 6. Therefore, the anode terminal 9 may be arranged in line with the cathode terminal 8. As the anode terminal 9 and the cathode terminal 8 are arranged in line, the cathode terminal 8 is not surrounded by the anode terminal 9 in the same manner of the first preferred embodiment, so that there is increased flexibility for wiring arrangements from the power source to both the terminals.
(7) The surface of the anode terminal 9 and the surface of the cathode terminal 8 are included in the substantially same plane.
   The anode terminal 9 is formed while the cathode terminal 8 is formed on the non-covered portion 51 of the cathode 5 which is not covered with the sealing layer 6. Accordingly, unlike in the case of providing a mask on the portion 51, the surface of the anode terminal 9 and the surface of the cathode terminal 8 are arranged on the substantially same plane.
   A third preferred embodiment of a lighting unit 200 according to the present invention will now be described with reference to FIGS. 4A and 4B. FIG. 4A is a schematic backside view of the lighting unit 200 according to the third preferred embodiment. FIG. 4B is a cross-sectional view that is taken along the line I-I in FIG. 4A.
   As shown in FIG. 4A, the lighting unit 200 is formed by arranging the organic EL elements 1 of the second preferred embodiment in a two-by-two matrix. Each anode terminal 8 of the organic EL elements 1 is connected to a positive electrode 201 of the lighting unit 200, and each cathode terminal 9 is connected to a negative electrode 202 of the lighting unit 200. All organic EL elements 1 are fixed to each other by a frame (not shown). The positive electrode 201 and the negative electrode 202 are fixed to a base 203. Additionally, a positive terminal 204, which is electrically connected to the positive electrode 201, and a negative terminal 205, which is electrically connected to the negative electrode 202, are provided along one side of the base 203. It is noted that the outline of the base 203 which should be indicated by a solid line is indicated by a dotted line, and the outlines of the organic EL elements 1, the anode terminal 8, the cathode terminal 9, the positive electrode 201, and the negative electrode 202, which should be indicated by dotted lines, are indicated by solid lines in FIG. 4A for easier recognition.
   A manner of electrical connection between the anode terminals 8 of the organic EL elements 1 and the positive electrode 201 of the lighting unit 200 and a manner of electrical connection between the cathode terminals 9 of the organic EL elements 1 and the negative electrode 202 of the lighting unit 200 will now be described.
   As shown in FIG. 4A, two of four organic EL elements 1 are arranged so that the respective anode terminals 8 are arranged on one line, and the respective cathode terminals 9 are arranged on one line. There are two pairs of the organic EL elements 1 and these pairs are in contact with each other.
   The positive electrode 201 of the lighting unit 200 includes two branches 201a connected to the anode terminals 8 of the organic EL elements 1 and a trunk 201b connected to the positive terminal 204 for connecting these two branches 201a. One branch 201 a is arranged to connect two anode terminals 8, which are inline with each other.
   Likewise, the negative electrode 202 of the lighting unit 200 includes two branches 202a connected to the cathode terminals 9 of the organic EL elements 1 and a trunk 202b connected to the negative terminal 205 for connecting these two branches 202a. One branch 202a is arranged to connect two cathode terminals 9, which are in line. Accordingly, all organic EL elements 1 are electrically arranged in a parallel relation to each other.
   The operation of the lighting unit 200 will now be described.
   As voltage is applied between the positive terminal 204 and the negative terminal 205 of the lighting unit 200, voltage is applied between the anode terminal 8 and the cathode terminal 9 of each organic EL element 1 through the positive electrode 201 and the negative electrode 202. Then, voltage is simultaneously applied between the anode terminals 8 and the cathode terminals 9 of all organic EL elements 1, so that all the organic EL elements 1 simultaneously emit light.
   According to the third preferred embodiment, the following advantageous effects are obtained.
(8) A lighting unit formed by plural lines of the organic EL elements 1 is obtained.
   Since all organic EL elements 1 are electrically connected in parallel with each other in the lighting unit 200, as voltage is applied between the positive terminal 204 and the negative terminal 205, all organic EL elements 1 simultaneously emit light. Since these organic EL elements 1 are arranged to contact each other, almost all portions of the organic EL elements 1 in the lighting unit 200 emits light due to the simultaneous light emission of the organic EL elements 1, thereby becoming a large lighting unit as a whole. As the plural organic EL elements 1 are arranged and simultaneously emit light to form a lighting unit, which is larger than each organic EL element 1, a yield rate as a product is raised in comparison to a large lighting unit formed by a single organic EL element 1 having the same size.
(9) The organic EL elements 1 forming the lighting unit 200 are easily replaced.
   The organic EL elements 1 forming the lighting unit 200 are connected to the electrodes (the positive electrode 201, the negative electrode 202) of the lighting unit at the opposite surface to the surface through which light is emitted. Therefore, when some of the organic EL elements 1 forming the lighting unit 200 fail or are degraded, such organic EL elements 1 may easily be removed and new organic EL elements 1 may easily be inserted into the lighting unit 200.
(10) Even if some of the organic EL elements 1 forming the lighting unit 200 are electrically disconnected, the remainder of the organic EL elements 1 continue to emit light.
   Since all organic EL elements 1 forming the lighting unit 200 are electrically connected in parallel with each other, even if some of them are electrically disconnected, there is no possibility that all organic EL elements 1 stop emitting light, as compared to an arrangement in which all organic EL elements 1 are electrically connected in series. Accordingly, even if one organic EL element 1 is not in contact with the electrodes of the lighting unit, the other organic EL elements 1 continue to emit light.

The present invention is not limited to the embodiments described above but may be modified into the following alternative embodiments.

In the first and second preferred embodiments, the light-emitting layer in the organic layer 4 is constituted of three layers including a green light-emitting layer, a blue light-emitting layer and a red light-emitting layer. The number of light-emitting layers is not limited to three. Two layers or a single layer is applicable. In order to obtain white light with a two-layer light-emitting layer, a specified color and its complementary color such as blue and yellow are emitted in the respective light-emitting layers. Also, a material for emitting a specified color may plurally be doped in a single layer. The plural luminescent materials are doped in the single layer to obtain white light even if the number of light-emitting layers is one or two.

The organic EL element 1 according to the first and second preferred embodiments emits white light, but emitting light may be light other than white light. The light-emitting layer of the organic EL element 1 is appropriately determined based upon a particular application and a specific employed material.

The EL element according to the first and second preferred embodiments is an organic EL element, but the EL layer may employ an inorganic electroluminescent element, which is made of an inorganic material.

In the organic EL element according to the first and second preferred embodiments, light from the light-emitting layer is output outside through the transparent substrate 2 and the transparent anode 3, but light may be emitted through the opposite surface to the substrate 2 relative to the light-emitting layer. In order to emit light through the opposite surface to the substrate 2, the cathode 3 and the cathode terminal 8 are made transparent. In this case, a material for a transparent electrode may employ a material for the anode 3 described in the first preferred embodiment.

In the first preferred embodiment, the thickness of the cathode 5 is 0.5 µ m or above all over, but the thickness of the cathode 5 need not be 0.5 µm or above all over. As far as the portion of the cathode terminal 9 is 0.5 µm or above, the other portion may be thinner. Since the portion of the cathode 5 other than the cathode terminal 9 is covered with the sealing layer 6, the portion of the cathode 5 need not have an airtightness and may have a thickness of 0.5 µm or below.

The lighting unit 200 according to the third preferred embodiment includes four organic EL elements 1 which are arranged in a two-by-two matrix, but the structure is not limited thereto. The number of the organic EL elements 1 and arrangement thereof may appropriately be changed when necessary.

In the lighting unit 200 according to the third preferred embodiment, all organic EL elements 1 are electrically connected in parallel with each other, but the organic EL elements 1 need not be all connected in parallel with each other. All organic EL elements 1 may be connected in series, or pairs of parallel organic EL elements 1 may be connected in series, or pairs of series organic EL elements 1 may be connected in parallel with each other. When all organic EL elements 1 are connected in series, electric current flowing in each organic EL element 1 becomes equal, so that luminescent brightness becomes substantially the same.

In the lighting unit 200 according to the third preferred embodiment, the organic EL elements 1 emit light from the side of the substrate 2, but an organic EL element which emits light from the opposite surface to the substrate 2 may be employed. In this case, the base 203, the positive electrode 201 and the negative electrode 202 are transparent. A material for the base 203 may employ a material for the substrate 2 described in the first preferred embodiment. A material for the positive electrode 201 and the negative electrode 202 may employ a material for the anode 3 described in the first preferred embodiment.

All or a portion of the above preferred embodiments may be combined together as far as conforming to the scope of the present invention.

Therefore, the present examples and embodiments are to be considered as illustrative and not restrictive, and the invention is not to be limited to the details given herein but may be modified within the scope of the appended claims.

In an electroluminescent element, a first electrode having first and second opposite surfaces is layered on a substrate so as to contact the substrate on its first surface. A luminescent layer containing a light-emitting layer is layered on the first electrode so as to contact the second surface of the first electrode. A second electrode having first and second opposite surfaces is layered on the luminescent layer so as to contact the luminescent layer on its first surface. The second surface of the second electrode is at least partially exposed. A first terminal is provided on the second surface of the first electrode at a portion that does not contact the luminescent layer. A second terminal is partially formed in the exposed portion. At least one of the first and second electrodes is transparent. The first and second terminals are connected to a power source.

## Claims

1. An electroluminescent element formed by a substrate, a first electrode, a luminescent layer, a second electrode, a first terminal and a second terminal, **characterized in that** the first electrode having a first surface and a second surface that is opposite to the first surface is layered on the substrate so as to contact the substrate on its first surface, **in that** the luminescent layer, which contains a light-emitting layer, is layered on the first electrode so as to contact the second surface of the first electrode, **in that** the second electrode having a first surface and a second surface that is opposite to the first surface is layered on the luminescent layer so as to contact the luminescent layer on its first surface, **in that** the second surface of the second electrode is at least partially exposed, **in that** the first terminal is provided on the second surface of the first electrode at a portion that does not contact the luminescent layer, **in that** the second terminal is partially formed in the exposed portion of second surface of the second electrode, **in that** at least one of the first electrode and the second electrode is transparent, and **in that** the first terminal and the second terminal are connected to a power source.

2. The electroluminescent element according to claim 1, wherein the luminescent layer is made of an organic compound.

3. The electroluminescent element according to any one of claims 1 and 2, wherein a portion of the second electrode forming the second terminal ranges from 0.5 µm to 1mm in thickness.

4. The electroluminescent element according to any one of claims 1 through 3, **characterized in that** a sealing member covers at least a portion of the luminescent layer that does not contact the first electrode or the second electrode.

5. The electroluminescent element according to any one of claims 1 through 4, wherein the second electrode is made of the same material as that of the first terminal.

6. The electroluminescent element according to any one of claims 1 through 5, wherein the substrate and the first electrode are transparent.

7. A lighting unit comprising a plurality of the electroluminescent elements according to any one of claims 1 through 6.

8. The lighting unit according to claim 7, wherein a plurality of the electroluminescent elements is electrically connected in parallel with each other.

9. The lighting unit according to any one of claims 7 and 8, wherein the electroluminescent elements are connected to electrodes of the lighting unit on a surface, which is opposite to a surface through which light is emitted.
